# EUROPÄISCHE PATENTSCHRIFT

(11) **EP 3 652 015 B1**
(45) Veröffentlichungstag und Bekanntmachung des Hinweises auf die Patenterteilung: **06.07.2022**
(21) Anmeldenummer: 18769044.1
(22) Anmeldetag: 23.08.2018
(51) Int. Cl.: B60L 5/20, B60L 5/30

(54) **VERFAHREN ZUR ÜBERPRÜFUNG EINER KONTAKTIERUNG EINES STROMABNEHMERS SOWIE STROMABNEHMER**
METHOD FOR TESTING WHETHER A CURRENT COLLECTOR IS IN CONTACT, AND CURRENT COLLECTOR
PROCÉDÉ DE CONTROLE DU CONTACT D'UN COLLECTEUR DE COURANT ET COLLECTEUR DE COURANT

(30) Priorität: 01.09.2017 DE 102017215340
(43) Veröffentlichungstag der Anmeldung: 20.05.2020
(73) Patentinhaber: Siemens Mobility GmbH, 81739 München (DE)
(72) Erfinder: BÜHS, Florian, 10777 Berlin (DE); STARK, Thomas, 15569 Woltersdorf (DE)
(86) Internationale Anmeldenummer: PCT/EP2018/072706
(87) Internationale Veröffentlichungsnummer: WO 2019/042848

(56) Entgegenhaltungen:
- DE-A1-102009 036 963
- DE-A1-102011 076 620
- FR-A1- 2 740 741
- JP-A- H11 136 804
- JP-A- 2001 235 310
- JP-A- 2002 328 063
- US-A- 5 386 895

## Beschreibung

Die Erfindung betrifft ein Verfahren zur Überprüfung einer Kontaktierung eines Stromabnehmers mit einem Fahrdraht sowie einen Stromabnehmer.

Heutzutage werden im Rahmen der Elektrifizierung des Automobilbereiches verschiedene Arten zur elektrischen Energieversorgung von elektromotorisch angetriebenen Fahrzeugen eingesetzt. Eine dieser Arten ist beispielsweise eine Versorgung eines derartigen Fahrzeuges mittels einer über einer Fahrbahn angeordneten Oberleitung, wie sie typischerweise bei Schienenfahrzeugen eingesetzt ist. Zur Energieversorgung weisen hierzu ausgebildete Fahrzeuge, speziell Lastkraftwagen einen Stromabnehmer auf, welcher mit der Oberleitung kontaktiert und somit die Energieversorgung sicherstellt.

Eine Kontaktierung des Stromabnehmers mit der Oberleitung ist nicht nur aus einer funktionalen Sicht hinsichtlich der Energieübertragung sicherzustellen, auch aus einem sicherheitstechnischen Hintergrund ist eine funktionsfähige Kontaktierung des Stromabnehmers mit der Oberleitung wichtig.

Aus der Offenlegungsschrift DE 10 2009 036 963 A1 ist ein Verfahren und eine Vorrichtung zur Messung von aerodynamischen Kraftanteilen bei der Kontaktkraftmessung zwischen einem Stromabnehmer und einer Oberleitung bekannt. Der Stromabnehmer weist mindestens eine Wippe auf, die mit mindestens einem Schleifleistenträger verbunden ist, der in Form eines als Hohlkörper ausgeführten Grundkörpers aufgebaut und mit einem Schleifstück gekoppelt ist. Das Schleifstück ist vollständig oder teilweise an Stelle der Schleifleiste (Schleifkohle) als U-förmiges Hohlprofil ausgebildet, welches mit seinem Boden auf dem Grundkörper (Schleifleistenträger) befestigt und zwischen den beiden Schenkeln des Hohlprofils einen Schleifkontakt aufweist. Auf dem Boden des Hohlprofils ist ein innerer Sensor befestigt, der sich am Schleifkontakt abstützt.

Ausgehend hiervon liegt der Erfindung die Aufgabe zugrunde ein Verfahren anzugeben, mit dessen Hilfe eine Kontaktierung eines Stromabnehmers mit einer Oberleitung einfach detektiert werden kann sowie einen Stromabnehmer anzugeben, der zur Durchführung des Verfahrens ausgebildet ist.

Die auf das Verfahren gerichtete Aufgabe wird erfindungsgemäß gelöst durch ein Verfahren mit den Merkmalen des Anspruchs 1.

Vorteilhafte Ausgestaltungen, Weiterbildungen und Varianten sind Gegenstand der Unteransprüche.

Das Verfahren ist zur Überprüfung einer Kontaktierung eines Stromabnehmers eines elektromotorisch angetriebenen Fahrzeuges mit einem Fahrdraht einer sich in eine Fahrtrichtung erstreckenden Oberleitung ausgebildet. Der Stromabnehmer ist insbesondere als ein Pantograph ausgebildet. Der Fahrdraht ist üblicherweise mittels mehrerer Tragseile zur elektrischen Versorgung des elektromotorisch angetriebenen Fahrzeugs oberhalb einer Fahrbahn angeordnet.

Unter elektromotorisch angetriebenem Fahrzeug wird vorliegend allgemein ein (Personen-)Kraftwagen und speziell ein Lastkraftwagen und / oder ein Bus verstanden, welcher einen Elektromotor als Fahrmotor aufweist, entweder nach Art eines hybriden Fahrzeugs (Kombination aus Verbrennungsmotor und Elektromotor) oder nach Art eines rein elektromotorisch angetriebenen Fahrzeugs. Bevorzugt ist das beschriebene elektromotorisch angetriebene Fahrzeug nicht schienengebunden und somit zum Befahren einer beispielsweise asphaltierten Fahrbahn ausgebildet. Der Einfachheit halber wird nachfolgend das elektromotorisch angetriebene Fahrzeug kurz als Fahrzeug bezeichnet.

Der Stromabnehmer ist in und entgegen einer Vertikalrichtung verfahrbar, d.h. insbesondere nach oben und nach unten, und weist ein Trägerelement auf. Das Trägerelement wird üblicherweise auch als Wippe oder Wippenkasten bezeichnet. Zudem ist das Trägerelement als eine Querleiste ausgebildet, also quer, insbesondere rechtwinklig zum Fahrdraht orientiert. Insbesondere ist das Trägerelement auch senkrecht zur Vertikalrichtung orientiert.

Weiterhin weist der Stromabnehmer eine mittels zumindest einem Primärfederelement, beispielsweise einem Schraubenfederelement federnd an dem Trägerelement gelagerte Schleifleiste auf. Die Schleifleiste ist bevorzugt ebenfalls als eine parallel zum Trägerelement orientierte Querleiste ausgebildet, also quer zur Fahrtrichtung orientiert und dient einer Kontaktierung mit dem Fahrdraht. Mit anderen Worten: Die Schleifleiste greift eine (Versorgungs-)Spannung ab, mit der der Fahrdraht typischerweise beaufschlagt, ist. Hierzu wird die Schleifleiste in Vertikalrichtung und insbesondere von unten an den Fahrdraht herangefahren und schleift im Fahrbetrieb an diesem. Bevorzugt weist das Fahrzeug zwei Schleifleisten auf, die voneinander beabstandet hintereinander angeordnet sind.

Zudem weist der Stromabnehmer eine Sensoreinheit zur Detektion der Kontaktierung des Stromabnehmers und insbesondere der Schleifleiste mit dem Fahrdraht auf. D.h. die Schleifleiste wird bei einer Kontaktierung mit dem Fahrdraht entgegen der Vertikalrichtung aus einer Ruheposition relativ zum Trägerelement ausgelenkt. Unter Ruheposition wird vorliegend speziell eine Position des Stromabnehmers, insbesondere eine Relativposition der Schleifleiste zu dem Trägerelement verstanden, bei der die Schleifleiste - mit Ausnahme der Schwerkraft - kräftefrei gelagert ist, beispielsweise bei eingefahrenem Stromabnehmer. Die Auslenkung beruht auf dem Hintergrund, dass die Schleifleiste bei einer Kontaktierung mit einer Andruckkraft "von unten" an den Fahrdraht gedrückt wird. Die Andruckkraft wird auch als Kontaktkraft bezeichnet. Der Fahrdraht übt seinerseits jedoch auch eine Gegenkraft auf die Schleifleiste aus. Mit anderen Worten: Aufgrund der Anordnung mittels der Tragseile und des Eigengewichts des Fahrdrahtes, "weicht" dieser kaum in Vertikalrichtung aus, wenn die Schleifleiste "von unten" an den Fahrdraht herangefahren wird. Somit werden die Primärfederelemente kraftbeaufschlagt und die Schleifleisten relativ zum Trägerelement ausgelenkt. Die Auslenkung der Schleifleiste relativ zum Trägerelement entspricht einem Abstand zwischen der Schleifleiste und dem Trägerelement. Der Abstand, d.h. die Auslenkung, ist insbesondere abhängig von der Andruckkraft und der entsprechenden Gegenkraft. Insbesondere wird bei einer höheren Andruckkraft, also einem stärkeren Andrücken der Schleifleiste an den Fahrdraht, die Auslenkung reduziert, d.h. verringert. Umgekehrt wird bei einer entsprechenden Entlastung die Auslenkung vergrößert.

Diese Auslenkung wird mittels der Sensoreinheit erfasst und anschließend wird ermittelt, ob die Schleifleiste mit dem Fahrdraht kontaktiert ist. Dies geschieht beispielsweise mittels eines Vergleiches der Auslenkung mit einem Auslenkungsschwellwert. Unter "Auslenkungsschwellwert" wird vorliegend speziell eine solche Auslenkung verstanden, ab der eine insbesondere funktionale Kontaktierung der Schleifleiste mit dem Fahrdraht erfolgt ist.

Mittels der Sensoreinheit wird demnach erkannt, ob und vorzugsweise auch in welchem Maß, sich die Auslenkung ändert, d.h. ob und vorzugsweise, wie stark sich die Auslenkung verringert oder vergrößert. Mit anderen Worten: die Auslenkung wird bei der Kontaktierung verändert, d.h. vergrößert oder verringert, und die Sensoreinheit erkennt die veränderte Auslenkung und quantifiziert diese vorzugsweise auch.

Hierdurch ist eine Detektion einer funktionalen Kontaktierung der Schleifleiste mit dem Fahrdraht und somit eine funktionsfähige elektrische Versorgung des Fahrzeuges sichergestellt. Weiterhin ist die Überprüfung der Kontaktierung unabhängig von einem elektrischen Zustand des Fahrdrahtes. Unter elektrischem Zustand wird vorliegend ein Betriebszustand des Fahrdrahtes verstanden, d.h., ob der Fahrdraht mit der (Versor-gungs-)Spannung beaufschlagt ist oder nicht.

Es wird eine Neigung der Schleifleiste relativ zum Trägerelement um eine sich in Fahrtrichtung erstreckende Neigungsachse erfasst. Der Vorteil ist, dass ergänzend zu der Erfassung der Auslenkung des Primärfederelements auch eine Erfassung eines durch die Neigung der Schleifleiste definierten Neigungswinkels erfolgen kann.

Bevorzugt weist die Sensoreinheit ein Magnetelement sowie ein Magnetsensorelement auf. Das Magnetelement und das Magnetsensorelement sind bevorzugt bei der Auslenkung relativ zueinander verschieblich oder beweglich.

Um eine einfache Erfassung der Auslenkung zu ermöglichen, wird gemäß einer zweckdienlichen Ausgestaltung eine Auslenkung des Primärfederelements in oder entgegen der Vertikalrichtung erfasst. Dies ermöglicht eine einfache Erfassung der Kontaktierung der Schleifleiste mit dem Fahrdraht.

Gemäß einer zweckdienlichen Weiterbildung ist die Schleifleiste mittels zwei voneinander beabstandeten Primärfederelementen federnd an dem Trägerelement angeordnet. Bevorzugt ist jeweils ein Primärfederelement seitlich (in Fahrtrichtung betrachtet links und rechts) an dem Trägerelement angeordnet.

Der Vorteil ist, dass insbesondere die Erfassung der Neigung der Schleifleiste genauer erfolgt als beispielsweise bei einer Ausgestaltung mit lediglich einem Federelement. Vorzugsweise sind hierbei auch zwei Sensoreinheiten angeordnet. Mit anderen Worten: Zur Erfassung der Neigung der Schleifleiste werden gemäß der beschriebenen Ausgestaltung zwei Auslenkungen (jeweils eine Auslenkung pro Federelement) herangezogen. In einer besonders bevorzugten Ausgestaltung ist jeweils eine Sensoreinheit nahe einem der Primärfederelemente angeordnet.

Dabei wird unter "nahe" insbesondere verstanden, dass die Sensoreinheit höchstens 5cm von dem zugehörigen Primärfederelement angeordnet ist.

Vorzugsweise sind die Primärfederelemente derart ausgebildet, dass sie bei der Kontaktierung der Schleifleiste mit dem Fahrdraht entgegen der Vertikalrichtung ausgelenkt werden. Hierbei wird die Auslenkung der Primärfederelemente erfasst.

Bevorzugt sind zur Erfassung der Auslenkung das Magnetelement sowie das Magnetsensorelement vorgesehen. Die Elemente (Magnetelement und Magnetsensorelement) sind bevorzugt verteilt an der Schleifleiste und an dem Trägerelement angeordnet, insbesondere gehalten. Unter verteilt wird vorliegend speziell verstanden, dass ein Element ausgewählt aus Magnetelement und Magnetsensorelement an der Schleifleiste angeordnet ist und das jeweils andere Element ausgewählt aus Magnetelement und Magnetsensorelement an dem Trägerelement angeordnet ist.

Alternativ oder ergänzend sind mehrere Magnetelemente und mit ihnen korrespondierende Magnetsensorelemente zur Erfassung der Auslenkung vorgesehen und auch angeordnet. Hierdurch wird die Erfassung nochmals weiter verbessert.

Das Magnetelement, beispielsweise ein Dauermagnet emittiert ein Magnetfeld, welches von dem Magnetsensorelement erfasst werden kann und auch erfasst wird. Bei einer Auslenkung der Schleifleiste relativ zum Trägerelement, also einer Auslenkung des Primärfederelements, werden auch die Elemente (Magnetelement und Magnetsensorelement) relativ zueinander verschoben, d.h. bewegt. Somit ist es ermöglicht, dass in Abhängigkeit eines vom Magnetsensorelement erfassten Magnetfeldes des Magnetelements die Auslenkung ermittelt wird.

In einer geeigneten Ausgestaltung ist das Magnetsensorelement als ein Sensorelement auf Basis eines magnetoresistiven Effekts ausgebildet. Bei der Beschreibung der nachfolgenden Konzepte wird ohne Beschränkung der Allgemeinheit von einer solchen Ausgestaltung unter Ausnutzung des magnetoresistiven Effekts ausgegangen. Die genannten Konzepte sind jedoch sinngemäß auch auf Ausgestaltungen mit Sensoreinheiten anderer Funktionsweise oder Bauart anwendbar, insbesondere mit anderen Magnetsensorelementen, welche alternativ oder zusätzlich andere Effekte nutzen. In einer geeigneten Ausführungsform ist das Magnetsensorelement als ein Hall-Sensor ausgeführt, welcher eine insbesondere vom Magnetfeld des Magnetelements abhängige und am Magnetsensorelement anliegende Spannung erfasst. Als weitere Alternativen werden Sensoreinheiten verwendet, welche einen sogenannten anisotropen magnetoresistiven Effekt (AMR)oder einen Riesenmagnetowiderstand-Effekt (GMR) nutzen, wobei sich allerdings die Erfassung der Auslenkung und die Bauweise der Sensoreinheit von den unten dargelegten Konzepten unterscheiden können.

Das Magnetsensorelement ist, wie bereits erwähnt, zur Erfassung von Magnetfeldern ausgebildet. Hierzu weist das Magnetsensorelement vorzugsweise zumindest zwei Schichten aus einem ferromagnetischen Material auf, die durch eine Zwischenschicht aus einem nicht ferromagnetischen Material getrennt sind. Bei einer derartigen Anordnung richten sich die Magnetisierungen der beiden Schichten aus dem ferromagnetischen Material in Abhängigkeit einer Dicke der nicht ferromagnetischen Zwischenschicht in entgegengesetzte Richtungen aus. Ein von außerhalb der Anordnung angelegtes Magnetfeld, kehrt die Orientierung in unterschiedliche Richtung zumindest teilweise um. Hieraus ergibt sich eine "Empfindlichkeit" der Sensoreinheit für Magnetfelder. Aufgrund dessen, dass ein elektrischer Widerstand der Anordnung mit der Orientierung der Magnetisierung korreliert, ist somit ein Magnetfeld, welches die Magnetisierung beeinflusst, über eine Änderung des Wertes des elektrischen Widerstandes messbar. Eine derartige Änderung der Magnetisierung erfolgt beispielsweise, wenn das Magnetsensorelement einem Magnetfeld ausgesetzt wird.

Mit anderen Worten: Durch die Auslenkung entgegen der Vertikalrichtung wird das Magnetsensorelement, das beispielsweise an dem Trägerelement angeordnet ist, mit dem Magnetfeld des Magnetelements beaufschlagt, wodurch sich die Magnetisierung und somit auch der Wert des elektrischen Widerstands des Magnetsensorelements ändert. Beispielsweise steigt der Wert des Widerstandes mit zunehmender Auslenkung. Diese Wertänderung des elektrischen Widerstandes wird anschließend beispielsweise mittels einer mit dem Magnetsensorelement drahtgebunden verbundenen Auswerteeinheit erfasst und ermittelt, ob die Schleifleiste mit dem Fahrdraht funktional kontaktiert ist. Hierzu wird beispielsweise ein Widerstandsschwellwert in der Auswerteeinheit hinterlegt, bei dessen Überschreiten eine funktionale Kontaktierung detektiert, also erkannt wird.

Die Empfindlichkeit des Magnetsensorelements für Magnetfelder ist vorliegend nicht auf eine bestimmte Orientierung des Magnetfeldes beschränkt. Hierdurch ist es ermöglicht, beispielsweise auch die Neigung der Schleifleiste mittels des Magnetsensorelements zu erfassen, das auch lediglich mit dem Magnetfeld beaufschlagte Teilbereiche des Magnetsensorelements zu einer messbaren Änderung des elektrischen Widerstandes des Magnetsensorelements führen.

Es wird die Neigung der Schleifleiste relativ zum Trägerelement erfasst. Weiterhin wird in Abhängigkeit der Neigung der Schleifleiste und der Auslenkung des Primärfederelements ein Kontaktierungspunkt des Fahrdrahtes aus der Schleifleiste detektiert. Unter Kontaktierungspunkt wird vorliegend speziell ein Punkt "auf" der Schleifleiste verstanden, mit dem die Schleifleiste mit dem Fahrdraht kontaktiert und somit an diesem schleift.

Mit anderen Worten: Wird der Stromabnehmer, insbesondere das Trägerelement in Fahrtrichtung betrachtet, so sind die Primärfederelemente vorzugsweise endseitig an dem Trägerelement und an der Schleifleiste angeordnet. Insbesondere sind dadurch im Betrieb die Primärfederelemente beidseitig des Fahrdrahts angeordnet. Bewegt sich nun das Fahrzeug beispielsweise (in Fahrtrichtung betrachtet) nach rechts, so verschiebt sich der Fahrdraht auf der Schleifleiste nach links. Hierdurch erfährt das linke Primärfederelement eine größere Auslenkung als das rechte Primärfederelement. Unter Auslenkung wird vorliegend speziell eine Auslenkung des linken Primärfederelements entgegen der Vertikalrichtung verstanden, also eine Stauchung des linken Primärfederelements und speziell für das rechte Primärfederelement eine Auslenkung in Vertikalrichtung, also eine Streckung oder Ausdehnung verstanden.

Die Schleifleiste neigt sich somit um einen Neigungswinkel um die sich in Fahrtrichtung erstreckende Drehachse nach links. Folglich sind das Magnetsensorelement und insbesondere ein linker Bereich des Magnetsensorelements beispielsweise stärker dem Magnetfeld des Magnetelements ausgesetzt als ein rechter Bereich des Magnetsensorelements. Alternativ ist die Schleifleiste so weit nach links ausgelenkt, dass der rechte Bereich des Magnetsensorelements überhaupt nicht mit dem Magnetfeld durchsetzt ist. Unter Heranziehung der Auslenkungen der beiden Primärfederelemente, insbesondere einer aus den beiden Auslenkungen resultierenden Auslenkung sowie eines Wertes des sich dadurch einstellenden Neigungswinkels, ist eine Ermittlung des Kontaktierungspunktes (vorliegend in einem linken Bereich der Schleifleiste) erreicht. Weiterhin wird der veränderte Wert des elektrischen Widerstandes mit herangezogen.

Beispielsweise ist jedem möglichen Kontaktierungspunkt ein bestimmter Auslenkungswert (wie weit die Primärfederelemente jeweils ausgelenkt oder gestaucht sind) und / oder ein sich einstellender Neigungswinkel in Kombination mit einem elektrischen Widerstandswert des Magnetsensorelements zugeordnet.

Gemäß einer zweckdienlichen Weiterbildung ist mittels zumindest eines Sekundärfederelements, beispielsweise eines Schraubenfederelements, ein Begrenzerelement an der Schleifleiste angeordnet, wobei eine Auslenkung der Schleifleiste und des Begrenzerelements relativ zum Trägerelement bei der Kontaktierung der Schleifleiste mit dem Fahrdraht erfasst wird. Vorzugsweise ist das Begrenzerelement mittels zwei voneinander beabstandeten Sekundärfederelementen an der Schleifleiste angeordnet. Hierzu sind die Sekundärfederelemente jeweils endseitig an dem Begrenzerelement und an der Schleifleiste angeordnet.

Das Begrenzerelement weist zudem seitlich über die Schleifleiste überstehende Endbereiche auf. Unter "Endbereiche" werden vorliegend speziell in Vertikalrichtung orientierte, beispielsweise gebogene Enden des Begrenzerelements verstanden. Insbesondere durch die überstehenden Endbereiche ist eine Erfassung eines Verlassens des Fahrdrahtes aus einem zulässigen Bereich ermöglicht. Unter dem zulässigen Bereich wird vorliegend ein Bereich der Schleifleiste verstanden, mit dem der Fahrdraht mechanisch kontaktiert sein muss, um auch eine elektrisch funktionsfähige Kontaktierung sicherzustellen. Üblicherweise entspricht der zulässige Bereich einer Breite der Schleifleiste. Unter Breite der Schleifleiste wird vorliegend eine - in Fahrtrichtung betrachtet - seitliche Ausdehnung (nach links und nach rechts) der Schleifleiste verstanden. Aufgrund dessen, dass der Fahrdraht innerhalb des zulässigen Bereiches "arbeitet" wird der zulässige Bereich üblicherweise auch als Arbeitsbereich und folglich das Begrenzerelement auch als Arbeitsbereichsbegrenzer bezeichnet.

Bevorzugt wird die Auslenkung der Schleifleiste und somit auch des Begrenzerelements relativ zum Trägerelement in Form einer Auslenkung des Sekundärfederelements in und entgegen der Vertikalrichtung erfasst. Ergänzend wird eine Neigung der Schleifleiste und somit auch des Begrenzerelements relativ zum Trägerelement um eine Neigungsachse erfasst. Die Neigungsachse erstreckt sich bevorzugt in Fahrtrichtung.

Der Vorteil ist, dass aufgrund der zusätzlichen Anordnung des Begrenzerelements die Erfassung der Auslenkung und der Neigung zur Detektion der Kontaktierung der Schleifleiste mit dem Fahrdraht und zur Detektion des Kontaktierungspunktes nicht beeinflusst wird.

Gemäß einer bevorzugten Ausgestaltung sind zur Erfassung der Auslenkung und / oder der Neigung das Magnetelement sowie das Magnetsensorelement vorgesehen. Gemäß dieser Ausgestaltung sind die Elemente (Magnetelement und Magnetsensorelement) verteilt an dem Begrenzerelement und an dem Trägerelement angeordnet. Unter "verteilt" wird vorliegend speziell verstanden, dass ein Element ausgewählt aus Magnetelement und Magnetsensorelement an dem Begrenzerelement angeordnet ist und das jeweils andere Element ausgewählt aus Magnetelement und Magnetsensorelement an dem Trägerelement angeordnet ist. Folglich wird die Auslenkung sowohl des Primärfederelements als auch des Sekundärfederelements sowie die Neigung der Schleifleiste um die Neigungsachse relativ zum Trägerelement in Abhängigkeit des von dem Magnetsensorelement erfassten Magnetfeldes des Magnetelements erfasst.

Zudem wird ein Verlassen des zulässigen Bereiches der Schleifleiste durch den Fahrdraht und ein Verlassen der Schleifleiste durch den Fahrdraht erfasst. Dies wird im Folgenden anhand eines Beispiels näher erläutert:
Verschiebt sich beispielsweise das Fahrzeug in Fahrtrichtung betrachtet nach rechts, sodass sich der Fahrdraht "auf" der Schleifleiste nach links verschiebt. Verschiebt sich nun das Fahrzeug so weit nach rechts und folglich der Fahrdraht so weit nach links, dass er von der Schleifleiste "rutscht", so stößt der Fahrdraht an das Begrenzerelement an, das mit zwei voneinander beabstandeten Sekundärfederelementen an der Schleifleiste angeordnet ist. Hierzu ist das Begrenzerelement jeweils endseitig, wie bereits erwähnt, beispielsweise in Vertikalrichtung ("nach oben") derart gebogen, dass der jeweils - nach oben - gebogene Teil des Begrenzerelements jeweils an den Enden der Schleifleiste anliegt.

Durch das Anstoßen des Fahrdrahts an das Begrenzerelement, insbesondere an den (nach oben) gebogenen linken Teil des Begrenzerelements wird das Begrenzerelement ausgelenkt. Im vorliegenden Beispiel wird das Begrenzerelement entgegen der Vertikalrichtung derart ausgelenkt, dass es sich nach links neigt. Somit wird beispielsweise das linke Sekundärfederelement entgegen der Vertikalrichtung ausgelenkt und das rechte Sekundärfederelement in Vertikalrichtung gestaucht. Eine Auslenkung der Primärfederelemente relativ zum Trägerelement, welche aufgrund der Kontaktierung der Schleifleiste mit dem Fahrdraht resultiert, sowie der Neigungswinkel der Schleifleiste werden beispielsweise beim Verlassen der Schleifleiste durch den Fahrdraht abrupt geändert. Unter abrupt geändert wird vorliegend speziell verstanden, dass beispielsweise das Primärfederelement bei einem Verlassen der Schleifleiste durch den Fahrdraht entgegen seiner durch den Fahrdraht bedingten Auslenkung zurückfedert. Dieses "Zurückfedern" wirkt sich ebenfalls auf das mittels des Sekundärfederelements an der Schleifleiste angeordneten Begrenzerelements aus. D.h. das beispielsweise an dem Begrenzerelement angeordnete Magnetelement "federt" mit, wodurch sich das "Mitfedern" beispielsweise in einem sprungartigen Verlauf des elektrischen Widerstandes des Magnetsensorelements zeigt.

Mit anderen Worten: Das Magnetsensorelement "verfolgt" und detektiert die Beaufschlagung mit dem Magnetfeld des Magnetelements. Bei einem Verlassen der Schleifleiste durch den Fahrdraht und der erwähnten federnden Bewegung der Schleifleiste und somit auch des Begrenzerelements wird das Magnetsensorelement beispielsweise von einem wechselnden Magnetfeld durchsetzt. Diese wechselnde Durchsetzung (das Magnetfeld taucht einmal durch die federnde Bewegung in das Magnetsensorelement ein und wieder heraus) mit dem Magnetfeld, ändert auch den gemessenen elektrische Widerstand des Magnetsensorelements sprungartig. Aufgrund dieses sprungartigen Verlaufes des gemessenen Widerstandswertes, kann anschließend auf ein Verlassen der Schleifleiste durch den Fahrdraht geschlossen werden.

Bevorzugt wird mittels der Sensoreinheit in Abhängigkeit der Auslenkung eine Kontaktkraft ermittelt, mit der die Schleifleiste mit dem Fahrdraht kontaktiert ist. Insbesondere wird hierbei die Auslenkung der Primärfederelemente herangezogen, da diese das Trägerelement direkt mechanisch mit der relativ zum Trägerelement ausgelenkten Schleifleiste verbinden.

Grundsätzlich bestehen zur Anordnung des Magnetelements und des Magnetsensorelements mehrere geeignete Möglichkeiten. In einer ersten Variante sind die beiden Elemente derart angebracht, dass diese aufeinander zu bewegt werden, wenn sich die Auslenkung zwischen der Schleifleiste und dem Trägerelement verringert. Hierbei ist dann die Auslenkung derart mit der Kontaktkraft korreliert, dass eine kleinere Auslenkung zwischen dem Trägerelement und der Schleifleiste einer größeren Kontaktkraft entspricht. Vorliegend wird unter kleinerer Auslenkung speziell eine Stauchung der beispielsweise als Schraubenfederelemente ausgebildeten Primärfederelemente verstanden. In einer zweiten Variante sind die beiden Elemente derart angebracht, dass diese voneinander wegbewegt werden, wenn sich die Auslenkung zwischen der Schleifleiste und dem Trägerelement verringert. Hierbei ist dann die Auslenkung derart mit der Kontaktkraft korreliert, dass eine größere Auslenkung zwischen dem Trägerelement und der Schleifleiste auch einer größeren Kontaktkraft entspricht.

Insbesondere im Zusammenhang mit der oben genannten zweiten Variante, weist der Stromabnehmer zweckmäßigerweise eine Halterung auf, welche an der Schleifleiste oder am Begrenzerelement angebracht ist. Die Halterung ist um das Trägerelement herumgeführt und umgreift dieses derart, dass das an der Halterung befestigte Element (Magnetsensorelement oder Magnetelement) insbesondere unterhalb des anderen Elements angeordnet ist. Infolgedessen wird bei einer Verringerung des Abstands zwischen der Schleifleiste und dem Trägerelement ein Abstand zwischen dem Magnetelement zum Magnetsensorelement vergrößert.

Vorteilhaft ist, dass mittels einer Sensoreinheit zwei Parameter, beispielsweise die Kontaktierung der Schleifleisten mit dem Fahrdraht und gleichzeitig die Kontaktkraft ermittelt werden können und vorzugsweise auch ermittelt werden. Weiterhin kann auf eine aufwändige Sensoreinheit, welche beispielsweise zu einer optischen Kraftmessung ausgebildet ist, verzichtet werden.

Die auf den Stromabnehmer gerichtete Aufgabe wird erfindungsgemäß gelöst durch einen Stromabnehmer mit den Merkmalen des Anspruchs 13.

Der Stromabnehmer ist derart ausgebildet, dass er zur Durchführung des zuvor beschriebenen Verfahrens dient.

Die im Hinblick auf das Verfahren aufgeführten Vorteile und bevorzugten Ausgestaltungen sind sinngemäß auf den Stromabnehmer zu übertragen und umgekehrt.

Der Stromabnehmer ist in und entgegen einer Vertikalrichtung verfahrbar und zu einer elektrischen Versorgung eines bevorzugt nicht schienengebundenen elektromotorisch angetriebenen Fahrzeuges ausgebildet. Hierzu kontaktiert der Stromabnehmer mit einem Fahrdraht einer sich in eine Fahrtrichtung erstreckenden Oberleitung. Insbesondere ist der Stromabnehmer nach Art eines Pantographen ausgebildet.

Hierzu weist der Stromabnehmer ein Trägerelement, üblicherweise auch als Wippenkasten bezeichnet auf. Das Trägerelement ist insbesondere als eine Querleiste ausgebildet, also quer, bevorzugt rechtwinklig zum Fahrdraht orientiert. Weiterhin weist der Stromabnehmer ein mit zumindest einem Primärfederelement federnd an dem Trägerelement angeordnete Schleifleiste zur Kontaktierung mit dem Fahrdraht auf. Die Schleifleiste ist somit bei einer Kontaktierung mit dem Fahrdraht aus der Ruheposition relativ zum Trägerelement auslenkbar.

Unter bei der Kontaktierung wird vorliegend zum einen ein Kontaktierungsvorgang verstanden, bei dem der Stromabnehmer in Vertikalrichtung an den Fahrdraht heran fährt und zum Anderen ein kontaktierter Zustand des Stromabnehmers mit dem Fahrdraht nach dem Heranfahren verstanden. Zur Erfassung der Auslenkung der Schleifleiste relativ zum Trägerelement weist der Stromabnehmer eine Sensoreinheit auf, wobei in Abhängigkeit der Auslenkung eine Auswertung erfolgt, ob die Schleifleiste mit dem Fahrdraht kontaktiert ist. Weiterhin ist die Schleifleiste ebenfalls als eine Querleiste ausgebildet und quer, bevorzugt rechtwinklig zum Fahrdraht orientiert.

Die Auswertung erfolgt alternativ oder ergänzend mittels einer Auswerteeinheit, die beispielsweise an einer Steuereinheit des Stromabnehmers angeordnet ist oder beispielsweise innerhalb des Fahrzeuges angeordnet ist. Die Auswerteeinheit ist hierbei vorzugsweise mittels einer drahtgebundenen oder drahtlosen Verbindung mit der Sensoreinheit verbunden, beispielsweise mittels einer elektrischen Leitung.

Bevorzugt weist die Sensoreinheit ein Magnetelement sowie ein Magnetsensorelement auf.

Gemäß einer bevorzugten Ausbildung ist das Magnetsensorelement als ein magnetoresistives Sensorelement, beispielsweise als ein Riesenmagnetowiderstands-Sensorelement (GMR-Sensorelement) ausgebildet. Unter dem magnetoresistiven Sensorelement wird vorliegend speziell ein Sensorelement verstanden, welches auf Basis eines magnetoresistiven Effekts arbeitet. Allgemein werden unter magnetoresistiven Effekten vorliegend Effekte verstanden, die eine Änderung eines elektrischen Widerstands eines Materials durch Anlegen eines äußeren Magnetfeldes beschreiben.

Alternative Ausgestaltungen der Sensoreinheit nutzen andere Funktionsweise oder weisen eine andere Bauart auf, insbesondere mit anderen Magnetsensorelementen, welche alternativ oder zusätzlich andere Effekte nutzen. Beispielsweise ist das Magnetsensorelement als ein Hall-Sensor ausgeführt, welcher eine insbesondere vom Magnetfeld des Magnetelements abhängige und am Magnetsensorelement anliegende Spannung erfasst. Des Weiteren werden insbesondere Sensoreinheiten verwendet, welche insbesondere einen sog. anisotropen magnetoresistiven Effekt (AMR)oder einen Riesenmagnetowiderstand-Effekt (GMR) nutzen.

Zweckdienlicherweise sind an der Schleifleiste und an dem Trägerelement verteilt das Magnetelement sowie das Magnetsensorelement angeordnet. Beispielsweise ist das Magnetsensorelement an dem Trägerelement angeordnet und das Magnetelement an der Schleifleiste angeordnet. Hierdurch ist eine einfache Erfassung der Auslenkung beispielsweise durch eine Beeinflussung des elektrischen Widerstandes des Magnetsensorelements durch das seitens des Magnetelements emittierten Magnetfeldes, wie es bereits bei der Beschreibung des Verfahrens aufgeführt ist.

Gemäß einer bevorzugten Weiterbildung ist ein Begrenzerelement mittels zumindest einem Sekundärfederelement, insbesondere mittels zwei Sekundärfederelementen federnd gelagert an der Schleifleiste angeordnet. Das Begrenzungselement ist insbesondere entgegen der Vertikalrichtung, also unterhalb der Schleifleiste angeordnet. Das Begrenzungselement weist zudem vorzugsweise jeweils endseitig in Vertikalrichtung ("nach oben") orientierte, beispielsweise gebogene Endbereiche auf. D.h. die Endbereiche erstrecken sich an den - in Fahrtrichtung betrachtet - seitlichen Enden der Schleifleiste entlang. Somit ist ein Verlassen der Schleifleiste durch den Fahrdraht wie bereits beschrieben detektierbar.

Sinnvollerweise sind das Magnetelement sowie das Magnetsensorelement verteilt an dem Begrenzungselement und an dem Trägerelement nach bereits beschriebener Weise angeordnet.

Gemäß einer vorteilhaften Weiterbildung sind zumindest zwei Sensoreinheiten angeordnet, zur Messung der Auslenkung und/ oder der Neigung an zwei unterschiedlichen Stellen. Besonders zweckmäßig ist eine Ausgestaltung, bei welcher zwei Primärfederelemente angeordnet sind und jeweils im Bereich des jeweiligen Primärfederelements, d.h. beispielsweise nicht weiter als 20cm oder insbesondere nicht weiter als 10cm von diesem entfernt, eine Sensoreinheit angeordnet ist, also insgesamt zwei Sensoreinheiten. Auf diese Weise kann vorteilhaft die Neigung und/oder die Auslenkung verbessert bestimmt werden.

Ausführungsbeispiele der Erfindung werden nachfolgend anhand der Figuren näher erläutert. Darin zeigen in teilweise stark vereinfachten Darstellungen:
- FIG 1: eine schematische Seitenansicht eines elektromotorisch angetriebenen Fahrzeugs,
- FIG 2: eine skizzierte Darstellung eines Stromabnehmers gemäß einer ersten Ausgestaltungsvariante,
- FIG 3: eine skizzierte Darstellung des Stromabnehmers gemäß einer zweiten Ausgestaltungsvariante,
- FIG 4: eine skizzierte Darstellung des Trägerelements gemäß der zweiten Ausgestaltungsvariante in einem ausgelenkten Zustand, und
- FIG 5: eine Seitenansicht des Stromabnehmers gemäß einer dritten Ausgestaltungsvariante.

In den Figuren sind gleichwirkende Teile mit den gleichen Bezugszeichen dargestellt.

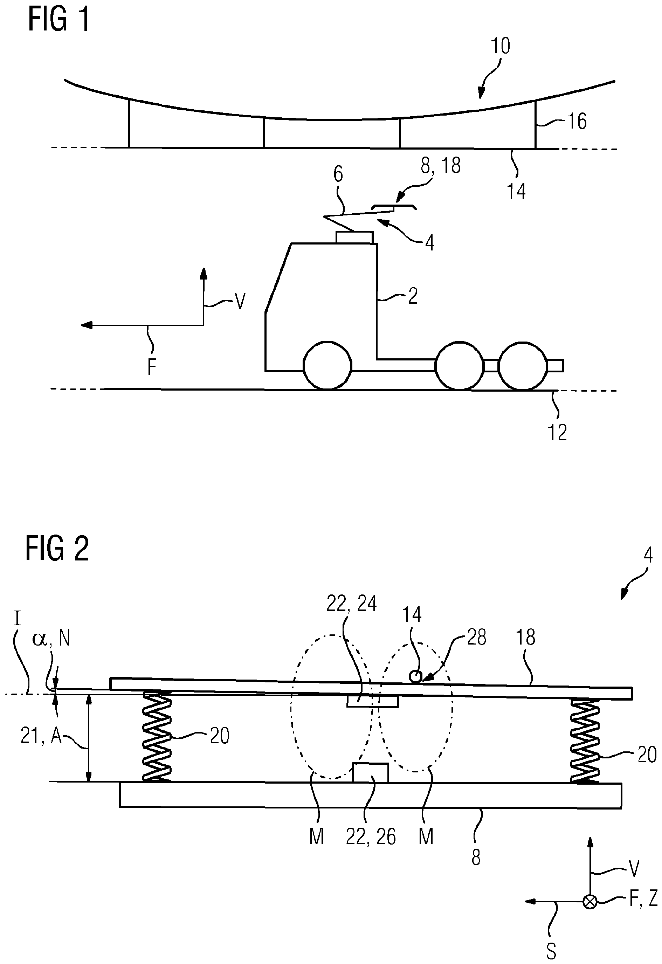

Das in FIG 1 gezeigte Fahrzeug 2 weist einen Stromabnehmer 4 auf, der im Ausführungsbeispiel auf dem Dach des Fahrzeuges 2 angeordnet ist. Der Stromabnehmer 4 weist einen Stromabnehmerarm 6 sowie ein an einem Ende des Stromabnehmerarms 6 angeordnetes Trägerelement 8 auf. Mit dem anderen Ende ist der Stromabnehmerarm 6 auf dem Dach des Fahrzeuges 2 angeordnet.

Der Stromabnehmer 4 ist in und entgegen einer Vertikalrichtung V verfahrbar und dient einer elektrischen Versorgung des Fahrzeuges 2 mit einer (Betriebs-)Spannung. Die Spannung wird üblicherweise mittels einer Oberleitung 10 bereitgestellt. Die Oberleitung 10 erstreckt sich in eine Fahrtrichtung F und ist oberhalb einer Fahrbahn 12 angeordnet. Weiterhin weist die Oberleitung 10 einen Fahrdraht 14 sowie mehrere Tragseile 16 zur Anordnung oberhalb der Fahrbahn 12 auf. Der Fahrdraht 14 ist üblicherweise mit der (Betriebs-)Spannung beaufschlagt.

Zum Abgreifen der (Betriebs-)Spannung weist der Stromabnehmer 4 an dem Trägerelement 8 angeordnete Schleifleisten 18 (vgl. FIG 2) auf. Die Schleifleisten 18 sind quer zum Fahrdraht 14 orientiert und werden zur Versorgung des Fahrzeuges 2 in Vertikalrichtung V ("von unten") an den Fahrdraht 14 herangefahren. Die Schleifleisten 18 schleifen somit im Fahrbetrieb an dem Fahrdraht 18 entlang und stellen die elektrische Versorgung des Fahrzeuges sicher.

In einer nicht dargestellten Alternative sind im Bereich der Primärfederelemente 20 jeweils eine weitere Sensoreinheit 22 angeordnet. Hierbei sind die Magnetelemente 24 jeweils nicht weiter als 10cm entfernt von derjenigen Stelle angeordnet, an welcher das zugeordnete Primärfederelement 20 an die Schleifleiste angebunden ist und die Magnetsensorelemente 26 jeweils nicht weiter als 10cm von derjenigen Stelle angeordnet, an welcher das zugeordnete Primärfederelement 20 an das Trägerelement 8 angebunden ist.

In FIG 2 ist eine skizzierte Darstellung eines Trägerelements 8 in Fahrtrichtung F betrachtet gemäß einer ersten Ausgestaltungsvariante dargestellt. An dem Trägerelement 8 ist mittels zwei Primärfederelementen 20 die Schleifleiste 18 angeordnet. Die Schleifleiste 18 ist im Ausführungsbeispiel in Vertikalrichtung, also oberhalb des Trägerelements 8 angeordnet. Hierzu ist jeweils ein Primärfederelement 20 endseitig an einer dem jeweilig anderen Element ausgewählt aus Trägerelement 8 und Schleifleiste 18 zugewandten Seite angeordnet. Sowohl die Schleifleiste 18 als auch das Trägerelement 8 sind im Ausführungsbeispiel als Querleisten ausgebildet und somit quer zum Fahrdraht 14 orientiert.

Durch die Primärfederelemente 20 ist die Schleifleiste 18 in und entgegen der Vertikalrichtung V federnd gelagert. Weiterhin weist die Schleifleiste 18 einen Abstand A zum Trägerelement 8 auf. Zur Erfassung einer Auslenkung der Schleifleiste 18 bei einer Kontaktierung mit dem Fahrdraht 14, weist der Stromabnehmer 4, insbesondere das Trägerelement 8 eine Sensoreinheit 22 auf. Die Sensoreinheit 22 weist ein Magnetelement 24, beispielsweise ein Dauermagnetelement sowie ein Magnetsensorelement 26, beispielsweise ein Riesenmagnetowiderstandselement auf.

Im Ausführungsbeispiel ist das Magnetelement 24 mittig an der Schleifleiste 18 angeordnet und emittiert ein dauerhaftes Magnetfeld M. Das Magnetsensorelement 26 ist im Ausführungsbeispiel an dem Trägerelement 8 angeordnet und zu einer Erfassung des Magnetfeldes M ausgebildet.

Beim Heranfahren des Stromabnehmers 4, insbesondere der Schleifleiste 18 an den Fahrdraht 14, wird die Schleifleiste 18 gegen den Fahrdraht 14 "gedrückt". Die Schleifleiste 18 und somit auch die Primärfederelemente 20 werden relativ zum Trägerelement 8 ausgelenkt, insbesondere entgegen der Vertikalrichtung V. D.h. der Abstand A wird verkleinert. Aufgrund dessen ändert sich auch eine Relativposition des Magnetelements 24 zu dem Magnetsensorelement 26, wodurch das Magnetsensorelement 26 eine Magnetfeldänderung erfasst. Beispielsweise steigt die magnetische Feldstärke des Magnetfeldes M mit kleiner werdendem Abstand A. Somit ist das Magnetsensorelement 26 bei einer Auslenkung durch eine Kontaktierung der Schleifleiste 18 mit dem Fahrdraht 14 einem stärkeren Magnetfeld M ausgesetzt als beispielsweise in einer Ruheposition. Unter Ruheposition wird vorliegend eine Position des Stromabnehmers 4 und insbesondere der Schleifleiste 18 verstanden, in der die Schleifleiste 18 beispielsweise nicht mit dem Fahrdraht 14 kontaktiert ist. Das stärkere Magnetfeld M hat beispielsweise innerhalb des Magnetsensorelements 26 eine Vergrößerung des elektrischen Widerstands des Magnetsensorelements 26 zur Folge, wobei eine derartige Änderung erfassbar ist.

Beispielsweise wird in einer hier nicht dargestellten Auswerteeinheit ein Schwellwert des elektrischen Widerstandes hinterlegt, bei dessen Überschreiten eine funktionale Kontaktierung der Schleifleiste 18 mit dem Fahrdraht 14 erfolgt.

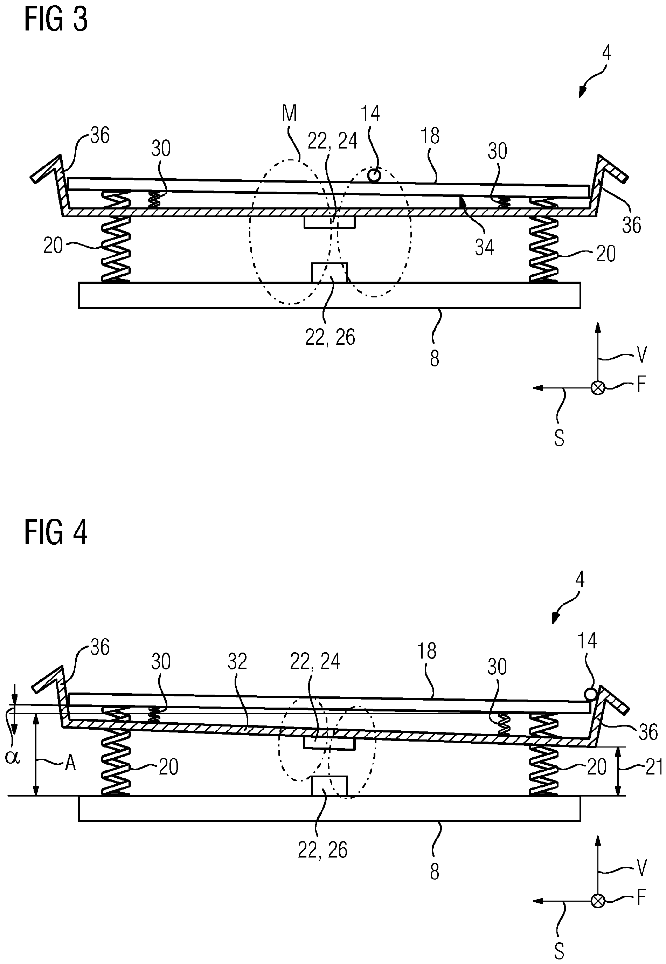

Ergänzend wird mittels der beschriebenen Anordnung auch eine Neigung der Schleifleiste 18 um einen Neigungswinkel α erfasst. Hierzu wird in Abhängigkeit einer Verschiebung des Fahrdrahtes 14 in oder entgegen einer Seitenrichtung S eine Auslenkung des - in Fahrtrichtung F betrachtet - linken Primärfederelements 20 und des rechten Primärfederelements 20 ermittelt. Eine unterschiedliche Auslenkung der beiden Primärfederelemente 20, beispielsweise aufgrund einer in Fahrtrichtung F betrachtet - nicht mittigen Kontaktierung der Schleifleiste 18 mit dem Fahrdraht 14 ist maßgebend für einen Wert des Neigungswinkels a. Mit anderen Worten: Kontaktiert beispielsweise ein in Fahrtrichtung F betrachtet rechter Bereich der Schleifleiste 18 mit dem Fahrdraht 14, so wird das rechte Primärfederelement 20 stärker entgegen der Vertikalrichtung ausgelenkt als das linke Primärfederelement 20. Somit neigt sich die Schleifleiste 18 "nach rechts", was im Ausführungsbeispiel eine Vergrößerung des Neigungswinkels α und eine Neigung des Magnetelements 24 zur Folge hat. Zugleich ändert sich aufgrund der Neigung eine Orientierung des Magnetfeldes M, das das Magnetsensorelement 26 durchsetzt. Im beschriebenen Beispiel wird ein rechter Bereich des Magnetsensorelements nun stärker mit dem Magnetfeld M durchsetzt als ein linker Bereich (in FIG 4 genauer erläutert). Diese ungleiche Magnetfelddurchsetzung wirkt sich erneut in einer erfassbaren Änderung des elektrischen Widerstands des Magnetsensorelements 26 aus.

Weiterhin kann aufgrund einer Kombination aus der Auslenkung der Primärfederelemente 20 und des Neigungswinkels α auf einen Kontaktierungspunkt 28 des Fahrdrahtes 14 "auf" der Schleifleiste 18 geschlossen werden. Hierzu werden beispielsweise die unterschiedlichen Auslenkungen der Primärfederelemente 20 zu einer resultierenden Auslenkung zusammengefasst und es kann aufgrund der erfassten Parameter (Neigungswinkel α und resultierende Auslenkung) auf den Kontaktierungspunkt 28 geschlossen werden.

In Abhängigkeit einer Auslenkung der Primärfederelemente 20 und einer Federkonstanten der Primärfederelemente 20 wird ebenfalls eine Kontaktkraft ermittelt, mit der die Schleifleiste 18 mit dem Fahrdraht 14 kontaktiert sind, also mit der die Schleifleiste 18 "gegen" den Fahrdraht 14 drückt.

In FIG 3 ist das Trägerelement 8 gemäß einer zweiten Ausgestaltungsvariante gezeigt. In FIG 3 weist das Trägerelement 8 alle Elemente und Einheiten 18,20,22,24,26, auf, wie sie bereits in der ersten Ausgestaltungsvariante beschrieben sind.

Zusätzlich ist jedoch an der Schleifleiste 18 mittels einer Anzahl an Sekundärfederelementen 30, im Ausführungsbeispiel zwei ein Begrenzerelement 32 angeordnet. Das Begrenzerelement 32 ist entgegen der Vertikalrichtung, also an einer Unterseite 34 der Schleifleiste 18 angeordnet. Mittels der Sekundärfederelemente 30 ist auch das Begrenzerelement 32 in und entgegen der Vertikalrichtung V federnd gelagert und somit relativ zum Trägerelement 8 und zur Schleifleiste 8 auslenkbar. Jeweils endseitig weist das Begrenzerelement 32 in Vertikalrichtung V, also nach oben orientierte, beispielsweise gebogene Endbereiche 36 auf. Die Endbereiche 36 umschließen somit (aufgrund der Anordnung des Begrenzerelements 32 "unterhalb" der Schleifleiste 18) die Schleifleiste 18. Mit anderen Worten: Aufgrund dessen, dass die Endbereiche 36 nach oben orientiert sind, "ragen" sie seitlich an den Enden der Schleifleiste 18 vorbei.

Weiterhin ist das Magnetelement 24 gemäß der zweiten Ausgestaltungsvariante an dem Begrenzerelement 32 angeordnet. Aufgrund der Anordnung des Begrenzerelements 32 an der Schleifleiste 18, wodurch somit auch das Begrenzerelement 32 bei einer Kontaktierung der Schleifleiste 18 mit dem Fahrdraht 14 relativ zum Trägerelement 8 ausgelenkt wird, ist eine Ermittlung der Kontaktierung der Schleifleiste 18 mit dem Fahrdraht 14 analog zur ersten Ausgestaltungsvariante gewährleistet.

Der zweiten Ausgestaltungsvariante liegt der Gedanke zugrunde, dass zusätzlich ein Verlassen der Schleifleiste 18 durch den Fahrdraht 14 detektiert werden kann. Unter Verlassen wird vorliegend speziell ein seitliches "Runterrutschen" des Fahrdrahtes 14 von der Schleifleiste 18 verstanden.

In FIG 4 wird die Detektion des Verlassens anhand eines Beispiels genauer erläutert.

FIG 4 zeigt das Trägerelement 8 des Stromabnehmers 4 sowie die Schleifleiste 18, wobei die Schleifleiste 18 in Fahrtrichtung F betrachtet seitlich ausgelenkt ist. Wie bereits in FIG 3 beschrieben wird im Folgenden das Verfahren zur Detektion des Verlassens der Schleifleiste 18 durch den Fahrdraht 14 näher erläutert:
Verschiebt ich beispielsweise das Fahrzeug 2 im Fahrbetrieb (und somit mit kontaktierter Verbindung der Schleifleiste mit dem Fahrdraht 14) in Fahrtrichtung betrachtet nach links, so verschiebt sich der Fahrdraht 14 auf der Schleifleiste 18 nach rechts. Beendet das Fahrzeug 2 die Verschiebung nach links nicht so verlässt der Fahrdraht 14 die Schleifleiste 18 in einem rechten Bereich.

Aufgrund dessen, dass die Endbereiche 36 des Begrenzerelements 32 seitlich an den Enden der Schleifleiste 18 vorbeiragen, "drückt" der Fahrdraht 14 gegen den jeweiligen Endbereich 36, im Ausführungsbeispiel gegen den rechten Endbereich 36. Dies hat eine Auslenkung des Begrenzerelements 32 relativ zum Trägerelement 8 zur Folge. Im Ausführungsbeispiel wird das rechte Sekundärfederelement 30 entgegen der Vertikalrichtung V ausgelenkt und das Begrenzerelement 32 neigt sich unter Ausbildung des Neigungswinkels α nach rechts. Aufgrund dessen, dass das Magnetelement 24 an dem Begrenzerelement 32 angeordnet ist, neigt sich dieses analog und durchsetzt somit nach bereits beschriebener Weise das an dem Trägerelement 8 angeordnete Magnetsensorelement 26 mit einem "geneigten" Magnetfeld M.

Da sowohl das Verlassen der Schleifleiste 18 als auch ein (meist unkritisches) Verschieben des Fahrdrahtes 14 auf der Schleifleiste 18 eine Auslenkung des Magnetelements 24 und somit ein geneigtes Magnetfeld M zur Folge haben, ist das Verlassen der Schleifleiste 18 von dem Verschieben des Fahrdrahtes 14 zu unterscheiden.

Hierzu wird beispielsweise ein Verlauf der aufgrund der Magnetfelddurchsetzung resultierenden Widerstandsänderung des Magnetsensorelements verfolgt. Diese Überlegung beruht darauf, dass bei einem Verlassen der Schleifleiste 18 durch den Fahrdraht 4 im Vergleich zu einem bloßen Verschieben des Fahrdrahtes 14 ein Sprung im Verlauf des Widerstandswertes wie bereits zuvor erwähnt erfassbar ist. Somit ist beispielsweise seitens der bereits erwähnten Auswerteeinheit bei Ermittlung eines derartigen Sprungs im Signalverlauf des Magnetsensorelements ein Verlassen der Schleifleiste 18 durch den Fahrdraht 14 eindeutig detektierbar.

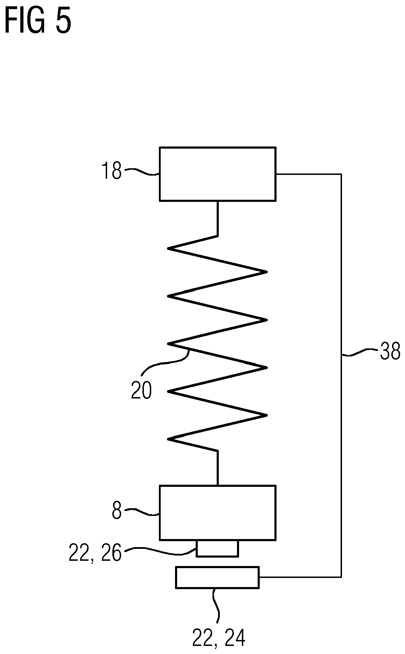

FIG 5 zeigt eine weitere Ausgestaltungsvariante des Stromabnehmers 4 mit Blickrichtung entlang des Trägerelements 8. Hierbei ist ein Abstand zwischen Magnetelement 24 und Magnetsensorelement 26 im Ruhezustand I entlang der Vertikalrichtung V am geringsten. Das Magnetsensorelement 26 ist dabei an der der Schleifleiste 18 abgewandten, in anderen Worten Fahrzeug 2 zugewandten, Seite des Trägerelements 8 angeordnet. Zudem ist an der Schleifleiste 18 eine Halterung 38 angeordnet, welche das Trägerelement 8 umgreift, so dass das an der Halterung 38 befestigte Magnetelement 24 zum Magnetsensorelement 26 vertikal in Richtung des Fahrzeugs 2 beabstandet angeordnet ist. So wird bei einer Verringerung des Abstands A zwischen der Schleifleiste 18 und dem Trägerelement 8 der Abstand zwischen dem Magnetelement 24 zum Magnetsensorelement 26 vergrößert.

In einer alternativen, nicht weiter dargestellten und sonst baugleichen Variante ist das Magnetsensorelement 26 an der Halterung 38 befestigt und das Magnetelement 24 am Trägerelement 8.

Ferner weist in einer weiteren, nicht dargestellten, alternativen Ausgestaltung des Stromabnehmers 4 gemäß FIG 3 das Begrenzerelement 32 die das Trägerelement 8 umgreifende Halterung 38 auf.

## Patentansprüche

1. Verfahren zur Überprüfung einer Kontaktierung eines Stromabnehmers (4) eines bevorzugt nicht schienengebundenen elektromotorisch angetriebenen Fahrzeugs (2) mit einem Fahrdraht (14) einer sich in einer Fahrtrichtung (F) erstreckenden Oberleitung (10), wobei der Stromabnehmer (4) in und entgegen einer Vertikalrichtung (V) verfahrbar ist und aufweist:
- ein Trägerelement (8) sowie
- eine an dem Trägerelement (8) gelagerte Schleifleiste (18) zur Kontaktierung mit dem Fahrdraht,
wobei der Stromabnehmer (4) eine Sensoreinheit (22) aufweist, **dadurch gekennzeichnet,**
- **dass** die Schleifleiste (18) mittels zumindest einem Primärfederelement (20) federnd am Trägerelement (8) gelagert ist,
- wobei die Schleifleiste (18) bei einer Kontaktierung mit dem Fahrdraht (14) entgegen der Vertikalrichtung (V) aus einer Ruheposition (I) relativ zum Trägerelement (8) ausgelenkt wird,
- wobei die Auslenkung (21) von der Sensoreinheit (22) erfasst wird und in Abhängigkeit der Auslenkung (21) ermittelt wird, ob die Schleifleiste (18) mit dem Fahrdraht (14) kontaktiert ist, und
- wobei mittels der Sensoreinheit (22) eine Neigung (N) der Schleifleiste (18) relativ zum Trägerelement (8) um eine sich in Fahrtrichtung (V) erstreckende Neigungsachse (Z) erfasst und in Abhängigkeit der Neigung (N) der Schleifleiste (18) und der Auslenkung des Primärfederelements ein Kontaktierungspunkt (28) des Fahrdrahtes (14) auf der Schleifleiste (18) detektiert wird.

2. Verfahren nach dem vorhergehenden Anspruch,
wobei die Sensoreinheit (22) ein Magnetelement (24) sowie ein Magnetsensorelement (26) aufweist, die bei der Auslenkung (21) relativ zueinander verschieblich sind.

3. Verfahren nach einem der beiden vorhergehenden Ansprüche,
wobei eine Auslenkung des Primärfederelements (20) in oder entgegen der Vertikalrichtung (V) erfasst wird.

4. Verfahren nach einem der vorhergehenden Ansprüche,
wobei die Schleifleiste (18) mittels zwei voneinander beabstandeten Primärfederelementen (20) federnd gelagert an dem Trägerelement (8) angeordnet ist.

5. Verfahren nach einem der vorhergehenden Ansprüche,
wobei die Primärfederelemente (20) derart ausgebildet sind, dass sie bei der Kontaktierung der Schleifleiste (18) mit dem Fahrdraht (14) entgegen der Vertikalrichtung (V) ausgelenkt werden, wobei die Auslenkung (21) erfasst wird.

6. Verfahren nach einem der vorhergehenden Ansprüche und Anspruch 2,
wobei zur Erfassung der Auslenkung (21) das Magnetelement (24) sowie das Magnetsensorelement (26) vorgesehen sind, die verteilt an der Schleifleiste (18) und an dem Trägerelement (8) angeordnet sind und, dass bei der Auslenkung (21) der Schleifleiste (18) relativ zum Trägerelement (8) die Auslenkung des Primärfederelements (20) in Abhängigkeit eines von dem Magnetsensorelement (26) erfassten Magnetfeldes (M) des Magnetelements (24) ermittelt wird.

7. Verfahren nach einem der vorhergehenden Ansprüche,
wobei mittels zumindest einem Sekundärfederelement (30) ein Begrenzerelement (32) mit seitlich über die Schleifleiste (18) überstehenden Endbereichen (36) an der Schleifleiste (18) angeordnet ist, wobei die Auslenkung (21) der Schleifleiste (18) und des Begrenzerelements (32) relativ zum Trägerelement (18) erfasst wird.

8. Verfahren nach dem vorhergehenden Anspruch,
wobei eine Auslenkung des Sekundärfederelements (30) in und entgegen der Vertikalrichtung (V) und / oder eine Neigung (N) der Schleifleiste (18) relativ zum Trägerelement (8) um eine sich in Fahrtrichtung (F) erstreckende Neigungsachse (Z) erfasst wird.

9. Verfahren nach dem vorhergehenden Anspruch und Anspruch 2,
wobei zur Erfassung der Auslenkung (21) und / oder der Neigung (N) das Magnetelement (24) sowie das Magnetsensorelement (26) vorgesehen sind, die verteilt an dem Begrenzerelement (32) und an dem Trägerelement (8) angeordnet sind, sodass die Auslenkung des Sekundärfederelements (30) und / oder die Neigung (N) der Schleifleiste (18) relativ zum Trägerelement (8) in Abhängigkeit eines von dem Magnetsensorelement (26) erfassten Magnetfeldes (M) des Magnetelements (24) ermittelt wird.

10. Verfahren nach einem der vorhergehenden Ansprüche, wobei mittels der Sensoreinheit in Abhängigkeit der Auslenkung eine Kontaktkraft ermittelt wird, mit der die Schleifleiste mit dem Fahrdraht kontaktiert ist.

11. Stromabnehmer (4) eines bevorzugt nicht schienengebundenen elektromotorisch angetriebenen Fahrzeuges (2) zur Kontaktierung mit einem Fahrdraht (14) einer Oberleitung (10), wobei sich der Fahrdraht (14) in eine Fahrtrichtung (F) erstreckt und der Stromabnehmer (4) in und entgegen einer Vertikalrichtung (V) verfahrbar ist und aufweist:
- ein Trägerelement (8),
- eine an dem Trägerelement (8) angeordnete Schleifleiste (18) zur Kontaktierung mit dem Fahrdraht (14),
**dadurch gekennzeichnet,**
- **dass** die Schleifleiste (18) mit zumindest einem Primärfederelement (20) am Trägerelement (8) federnd angeordnet ist, sodass die Schleifleiste (18) bei einer Kontaktierung mit dem Fahrdraht (14) aus einer Ruheposition (I) relativ zum Trägerelement (8) auslenkbar ist sowie
- **dass** der Stromabnehmer (4) eine Sensoreinheit (22) zur Erfassung der Auslenkung (21) aufweist,
- wobei in Abhängigkeit der Auslenkung (21) eine Auswertung erfolgt, ob die Schleifleiste (18) mit dem Fahrdraht (14) kontaktiert ist, und
- wobei mittels der Sensoreinheit (22) eine Neigung (N) der Schleifleiste (18) relativ zum Trägerelement (8) um eine sich in Fahrtrichtung (V) erstreckende Neigungsachse (Z) erfasst und in Abhängigkeit der Neigung (N) der Schleifleiste (18) und der Auslenkung des Primärfederelements ein Kontaktierungspunkt (28) des Fahrdrahtes (14) auf der Schleifleiste (18) detektiert wird.

12. Stromabnehmer (4) nach dem vorhergehenden Anspruch, wobei die Sensoreinheit (22) ein Magnetelement (24) sowie ein Magnetsensorelement (26) aufweist.

13. Stromabnehmer (4) nach einem der beiden vorhergehenden Ansprüche,
wobei das Magnetsensorelement (26) als ein magnetoresistives Sensorelement ausgebildet ist.

14. Stromabnehmer (4) nach einem der vorhergehenden Ansprüche 11-13,
wobei an der Schleifleiste (18) und am Trägerelement (8) verteilt das Magnetelement (24) sowie das Magnetsensorelement (26) angeordnet sind.

15. Stromabnehmer (4) nach einem der vorhergehenden Ansprüche 11-14,
wobei das Magnetelement (24) und das Magnetsensorelement (26) derart angebracht sind, dass diese voneinander weg bewegtwerden, wenn sich die Auslenkung (21) zwischen der Schleifleiste (18) und dem Trägerelement (8) verringert.

16. Stromabnehmer (4) nach einem der Ansprüche 13 bis 15, wobei ein Begrenzerelement (32) mittels zumindest einem Sekundärfederelement (30) federnd gelagert an der Schleifleiste (18) angeordnet ist.

17. Stromabnehmer (4) nach dem vorhergehenden Anspruch,
wobei das Magnetelement (24) und das Magnetsensorelement (26) verteilt an dem Begrenzerelement (32) und an dem Trägerelement (18) angeordnet sind.

18. Stromabnehmer (4) nach einem der vorhergehenden Ansprüche 11-17,
wobei zumindest zwei Sensoreinheiten (22) angeordnet sind, zur Messung der Auslenkung (21) und/oder der Neigung (N) an zwei unterschiedlichen Stellen.

## Claims

1. Method for testing whether a current collector (4) of a preferably not rail-bound, electric motor-driven vehicle (2) is in contact with a contact wire (14) of an overhead line (10) extending in a direction of travel (F), wherein the current collector (4) is movable in and counter to a vertical direction (V) and comprises:
- a carrier element (8) and
- a contact strip (18) mounted on the carrier element (8) for contacting the contact wire,
wherein the current collector (4) comprises a sensor unit (22),
**characterised in that**
- the contact strip (18) is resiliently mounted on the carrier element (8) by means of at least one primary spring element (20),
- wherein the contact strip (18) upon contacting the contact wire (14) is deflected out of a rest position (I) counter to the vertical direction (V) relative to the carrier element (8),
- wherein the deflection (21) is detected by the sensor unit (22) and, dependent upon the deflection (21), it is determined whether the contact strip (18) is contacted by the contact wire (14), and
- wherein an inclination (N) of the contact strip (18) relative to the carrier element (8) about an inclination axis (Z) extending in the direction of travel (V) is detected by means of the sensor unit (22) and dependent upon the inclination (N) of the contact strip (18) and the deflection of the primary spring element a contacting point (28) of the contact wire (14) is detected on the contact strip (18).

2. Method according to the preceding claim,
wherein the sensor unit (22) comprises a magnet element (24) and a magnetic sensor element (26) which are displaceable relative to one another during the deflection (21).

3. Method according to one of the two preceding claims,
wherein a deflection of the primary spring element (20) in or counter to the vertical direction (V) is detected.

4. Method according to one of the preceding claims,
wherein the contact strip (18) is arranged resiliently mounted on the carrier element (8) by means of two primary spring elements (20) spaced apart from one another.

5. Method according to one of the preceding claims,
wherein the primary spring elements (20) are configured such that when the contact strip (18) makes contact with the contact wire (14), said primary spring elements are deflected counter to the vertical direction (V), wherein the deflection (21) is detected.

6. Method according to one of the preceding claims and claim 2,
wherein for detecting the deflection (21), the magnet element (24) and the magnetic sensor element (26) are provided arranged distributed on the contact strip (18) and on the carrier element (8) and, in that on deflection (21) of the contact strip (18) relative to the carrier element (8), the deflection of the primary spring element (20) is determined dependent upon a magnetic field (M) of the magnet element (24) detected by the magnetic sensor element (26).

7. Method according to one of the preceding claims,
wherein by means of at least one secondary spring element (30), a limiter element (32) with end regions (36) protruding laterally beyond the contact strip (18) is arranged on the contact strip (18), wherein the deflection (21) of the contact strip (18) and of the limiter element (32) relative to the carrier element (18) is detected.

8. Method according to one of the preceding claims,
wherein a deflection of the secondary spring element (30) in and counter to the vertical direction (V) and/or an inclination (N) of the contact strip (18) relative to the carrier element (8) about an inclination axis (Z) extending in the direction of travel (F) is detected.

9. Method according to the preceding claim and claim 2,
wherein for detecting the deflection (21) and/or the inclination (N), the magnet element (24) and the magnetic sensor element (26) are provided arranged distributed on the limiter element (32) and on the carrier element (8), so that the deflection of the secondary spring element (30) and/or the inclination (N) of the contact strip (18) relative to the carrier element (8) is determined dependent upon a magnetic field (M) of the magnet element (24) detected by the magnetic sensor element (26).

10. Method according to one of the preceding claims,
wherein a contact force with which the contact wire contacts the contact strip is determined by means of the sensor unit, dependent upon the deflection.

11. Current collector (4) of a preferably not rail-bound, electric motor-driven vehicle (2) for contacting a contact wire (14) of an overhead line (10), wherein the contact wire (14) extends in a direction of travel (F) and the current collector (4) is movable in and counter to a vertical direction (V) and comprises:
- a carrier element (8),
- a contact strip (18) mounted on the carrier element (8) for contacting the contact wire (14),
**characterised in that**
- the contact strip (18) is resiliently arranged on the carrier element (8) by means of at least one primary spring element (20) so that, on contacting the contact wire (14), the contact strip (18) is deflectable out of a rest position (I) relative to the carrier element (8), and
- that the current collector (4) comprises a sensor unit (22) for detecting the deflection (21),
- wherein dependent upon the deflection (21), an evaluation takes place of whether the contact strip (18) is in contact with the contact wire (14), and
- wherein an inclination (N) of the contact strip (18) relative to the carrier element (8) about an inclination axis (Z) extending in the direction of travel (V) is detected by means of the sensor unit (22) and dependent upon the inclination (N) of the contact strip (18) and the deflection of the primary spring element a contacting point (28) of the contact wire (14) is detected on the contact strip (18).

12. Current collector (4) according to the preceding claim, wherein the sensor unit (22) comprises a magnet element (24) and a magnetic sensor element (26).

13. Current collector (4) according to one of the two preceding claims,
wherein the magnetic sensor element (26) is configured as a magnetoresistive sensor element.

14. Current collector (4) according to one of claims 11-13, wherein the magnet element (24) and the magnetic sensor element (26) are arranged distributed on the contact strip (18) and on the carrier element (8).

15. Current collector (4) according to one of the preceding claims 11-14,
wherein the magnet element (24) and the magnetic sensor element (26) are mounted such that they are moved away from one another if the deflection (21) between the contact strip (18) and the carrier element (8) becomes reduced.

16. Current collector (4) according to one of claims 13 to 15, wherein a limiter element (32) is arranged resiliently mounted on the contact strip (18) by means of at least one secondary spring element (30).

17. Current collector (4) according to the preceding claim, wherein the magnet element (24) and the magnetic sensor element (26) are arranged distributed on the limiter element (32) and on the carrier element (18).

18. Current collector (4) according to one of the preceding claims 11-17,
wherein at least two sensor units (22) are arranged for measuring the deflection (21) and/or the inclination (N) at two different sites.

## Revendications

1. Procédé de contrôle d'une mise en contact d'un appareil (4) de prise de courant d'un véhicule (2) entraîné par un moteur électrique, de préférence non guidé sur rail, avec un fil (14) de contact d'une ligne (10) de contact s'étendant dans une direction (F) de circulation, dans lequel l'appareil (4) de prise de courant peut se déplacer dans un sens (V) vertical et en sens contraire et a :
- un élément (8) de support ainsi que
- une plaque (18) d'usure montée sur l'élément (8) de support pour la mise en contact avec le fil de contact,
dans lequel l'appareil (4) de prise de courant a une unité (22) de capteur,
**caractérisé**
- **en ce que** la plaque (18) d'usure est montée élastiquement sur l'élément (8) de support au moyen d'un élément (20) primaire de ressort,
- dans lequel la plaque (18) d'usure est, lors d'une mise en contact avec le fil (14) de contact, déviée dans le sens contraire au sens (V) vertical d'une position (I) de repos par rapport à l'élément (8) de support,
- dans lequel on détecte la déviation (21) par l'unité (22) de capteur et on détermine en fonction de la déviation (21) si la plaque (18) d'usure est contactée par le fil (14) de contact, et
- dans lequel, au moyen de l'unité (22) de capteur, on détecte une inclinaison (N) de la plaque (18) d'usure par rapport à l'élément (8) de support autour d'un axe (Z) d'inclinaison s'étendant dans la direction (V) de circulation et, en fonction de l'inclinaison (N) de la plaque (18) d'usure et de la déviation de l'élément primaire de ressort, on détecte un point (28) de contact du fil (14) de contact sur la plaque (18) d'usure.

2. Procédé suivant la revendication précédente,
dans lequel l'unité (22) de capteur à un élément (24) d'aimant ainsi qu'un élément (26) de capteur d'aimant, qui sont montés déplaçables l'un par rapport à l'autre lors de la déviation (21).

3. Procédé suivant l'une des deux revendications précédentes,
dans lequel on détecte une déviation de l'élément (20) primaire de ressort dans le sens (V) vertical ou en sens contraire.

4. Procédé suivant l'une des revendications précédentes,
dans lequel la plaque (18) d'usure est montée élastiquement sur l'élément (8) de support au moyen de deux éléments (20) primaires de ressort à distance l'un de l'autre.

5. Procédé suivant l'une des revendications précédentes,
dans lequel les éléments (20) primaires de ressort sont constitués de manière à être déviés en sens contraire au sens (V) vertical, lors de la mise en contact de la plaque (18) d'usure avec le fil (14) de contact, dans lequel on détecte la déviation (21).

6. Procédé suivant l'une des revendications précédentes et la revendication 2,
dans lequel, pour la détection de la déviation (21) sont prévus l'élément (24) d'aimant ainsi que l'élément (26) de capteur d'aimant, qui sont disposés de manière répartie sur la plaque (18) d'usure et sur l'élément (8) de support et en ce que, lors de la déviation (21) de la plaque (18) d'usure par rapport à l'élément (8) de support, on détermine la déviation de l'élément (20) primaire de ressort en fonction d'un champ (M) magnétique de l'élément (24) d'aimant détecté par l'élément (26) de capteur d'aimant.

7. Procédé suivant l'une des revendications précédentes,
dans lequel, au moyen d'au moins un élément (30) secondaire de ressort, un élément (32) limiteur, ayant des parties (36) d'extrémité dépassant latéralement de la plaque (18) d'usure, est monté sur la plaque (18) d'usure, dans lequel on détecte la déviation (21) de la plaque (18) d'usure et de l'élément (32) limiteur par rapport à l'élément (18) de support.

8. Procédé suivant la revendication précédente,
dans lequel on détecte une déviation de l'élément (30) secondaire de ressort dans le sens (V) vertical et en sens contraire et/ou une inclinaison (N) de la plaque (18) d'usure par rapport à l'élément (8) de support, autour d'un axe (Z) d'inclinaison s'étendant dans la direction (F) de circulation.

9. Procédé suivant la revendication précédente et la revendication 2,
dans lequel, pour la détection de la déviation (21) et/ou de l'inclinaison (N) sont prévus l'élément (24) d'aimant ainsi que l'élément (26) de capteur d'aimant, qui sont disposés de manière répartie sur l'élément (32) limiteur et sur l'élément (8) de support, de manière à déterminer la déviation de l'élément (30) secondaire de ressort et/ou l'inclinaison (N) de la plaque (18) d'usure par rapport à l'élément (8) de support en fonction d'un champ (M) magnétique de l'élément (24) d'aimant détecté par l'élément (26) de capteur d'aimant.

10. Procédé suivant l'une des revendications précédentes,
dans lequel on détermine au moyen de l'élément de capteur, en fonction de la déviation, une force de contact avec laquelle la plaque d'usure est mise en contact avec le fil de contact.

11. Appareil (4) de prise de courant d'un véhicule (2) entraîné par un moteur électrique, de préférence non guidé sur rail, à mettre en contact avec un fil (14) de contact d'une ligne (10) de contact, dans lequel le fil (14) de contact s'étend dans une direction (F) de circulation et l'appareil (4) de prise de courant peut se déplacer dans un sens (V) vertical et en sens contraire et a :
- un élément (8) de support
- une plaque (18) d'usure montée sur l'élément (8) de support pour la mise en contact avec le fil (14) de contact,
**caractérisé**
- **en ce que** la plaque (18) d'usure est montée élastiquement sur l'élément (8) de support par au moins un élément (20) primaire de ressort, de manière à ce que la plaque (18) d'usure puisse, lors d'une mise en contact avec le fil (14) de contact, être déviée d'une position (I) de repos, par rapport à l'élément (8) de support ainsi que
- **en ce que** l'appareil (4) de prise de courant a une unité (22) de capteur de détection de la déviation (21),
- dans lequel il se produit, en fonction de la déviation (21), une évaluation sur le point de savoir si la plaque (18) d'usure est en contact avec le fil (14) de contact, et
- dans lequel, au moyen de l'unité (22) de capteur, on détecte une inclinaison (N) de la plaque (18) d'usure par rapport à l'élément (8) de support autour d'un axe (Z) d'inclinaison s'étendant dans la direction (V) de circulation, et en fonction de l'inclinaison (N) de la plaque (18) d'usure et de la déviation de l'élément primaire de ressort, on détecte un point (28) de contact du fil (14) de contact sur la plaque (18) d'usure.

12. Appareil (4) de prise de courant suivant la revendication précédente,
dans lequel l'unité (22) de capteur a un élément (24) d'aimant ainsi qu'un élément (26) de capteur d'aimant.

13. Appareil (4) de prise de courant suivant l'une des deux revendications précédentes,
dans lequel l'élément (26) de capteur d'aimant est constitué sous la forme d'un élément de capteur magnétorésistif.

14. Appareil (4) de prise de courant suivant l'une des revendications 11 à 13 précédentes,
dans lequel l'élément (24) d'aimant ainsi que l'élément (26) de capteur d'aimant sont disposés de manière répartie sur la plaque (18) d'usure et sur l'élément (8) de support.

15. Appareil (4) de prise de courant suivant l'une des revendications 11 à 14 précédentes,
dans lequel l'élément (24) d'aimant et l'élément (26) de capteur d'aimant sont mis de manière à s'éloigner l'un de l'autre, lorsque la déviation (21) entre la plaque (18) d'usure et l'élément (8) de support diminue.

16. Appareil (4) de prise de courant suivant l'une des revendications 13 à 15,
dans lequel un élément (32) limiteur est monté élastiquement sur la plaque (18) d'usure au moyen d'un élément (30) secondaire de ressort.

17. Appareil (4) de prise de courant suivant la revendication précédente,
dans lequel l'élément (24) d'aimant et l'élément (26) de capteur d'aimant sont disposés de manière répartie sur l'élément (32) limiteur et sur l'élément (18) de support.

18. Appareil (4) de prise de courant suivant l'une des revendications 11 à 17 précédentes,
dans lequel il est disposé au moins deux unités (22) de capteur pour la mesure de la déviation (21) et/ou de l'inclinaison (N) en deux endroits différents.
